# EUROPEAN PATENT APPLICATION

(11) **EP 3 778 983 A1**
(43) Date of publication of application: **17.02.2021**
(21) Application number: 19774379.2
(22) Date of filing: 26.03.2019
(51) Int. Cl.: C23C 14/32, C23C 14/34, C23C 14/56

(54) **TARGET EXCHANGING DEVICE AND SURFACE TREATMENT FACILITY**

(30) Priority: 30.03.2018 JP 2018067195
(71) Applicant: JFE Steel Corporation, Tokyo 100-0011 (JP)
(72) Inventor: UMADA Takumi, Tokyo 100-0011 (JP); SHINGAKI Yukihiro, Tokyo 100-0011 (JP)
(74) Representative: Hoffmann Eitle
(86) International application number: PCT/JP2019/012770
(87) International publication number: WO 2019/189122

(57) **Abstract**

Provided are a target exchanging device for easily exchanging targets used in PVD and a surface treatment facility that uses the same. This target exchanging device exchanges targets. The targets are used for carrying out surface treatment, by PVD, on a surface treatment material in a depressurized space inside a chamber. The target exchanging device includes: a target holder for holding the target; a detachment mechanism that detachably attaches the target holder to the chamber at a position in the depressurized space where the target faces the material subjected to surface treatment; and a cut-off mechanism that openably cuts off the target holder attached to the chamber from the depressurized space.

## Description

### TECHNICAL FIELD

The present invention relates to a target replacement apparatus and a surface treatment facility.

### BACKGROUND ART

Grain oriented electrical steel sheets are soft magnetic materials used as materials for iron cores of transformers, generators and the like. Grain oriented electrical steel sheets have a crystal structure in which the <001> orientation that is an easy magnetization axis of iron is highly-precisely aligned in the rolling direction of the steel sheet. The texture as above is formed through final annealing of a manufacturing process of a grain oriented electrical steel sheet, which final annealing allows crystal grains with the {110}<001> orientation referred to as the so-called Goss orientation to preferentially grow to an enormous size. Grain oriented electrical steel sheets as products are required to have such magnetic properties as high magnetic flux density and low iron loss.

The magnetic properties of a grain oriented electrical steel sheet are improved by applying a tensile stress (tension) to a steel sheet surface. As one conventional technique of applying a tensile stress to a steel sheet, a technique in which a forsterite coating of about 2 µm thickness is formed on a steel sheet surface and another coating of about 2 µm thickness primarily composed of silicon phosphate is formed on the forsterite coating is typically used. The silicon phosphate coating having a lower thermal expansion coefficient than that of the steel sheet is formed at high temperature and cooled to room temperature, whereby a tensile stress is applied to the steel sheet using a difference in thermal expansion coefficient between the steel sheet and the silicon phosphate coating. This silicon phosphate coating also acts as an insulating coating that is indispensable for a grain oriented electrical steel sheet. Owing to the insulation, a local eddy current is prevented from being generated in the steel sheet.

A surface of the grain oriented electrical steel sheet having undergone final annealing is smoothed by chemical polishing or electrolytic polishing, and then a tensile stress is applied by means of the coating above the steel sheet, whereby iron loss can remarkably be decreased.

Meanwhile, the forsterite coating between the steel sheet and the silicon phosphate coating adheres to the steel sheet owing to the anchoring effect. Therefore, the smoothness of the steel sheet surface inevitably deteriorates. Further, the adhesion between silicon phosphate and metal is so low that a silicon phosphate coating cannot be formed directly on a mirror-finished surface of a steel sheet. Thus, in the coating structure of a conventional grain oriented electrical steel sheet (steel sheet/ forsterite coating/ silicon phosphate coating), a surface of a steel sheet cannot be smoothed.

To cope with it, techniques are disclosed in which, in order to maintain the smoothness of a steel sheet surface and also apply a large tensile stress to the steel sheet, a ceramic coating composed of TiN for instance is formed on the steel sheet by a CVD method or a PVD method (see Patent Literatures 1 and 2).

### CITATION LIST

### PATENT LITERATURES

Patent Literature 1: JP 01-176034 A
Patent Literature 2: JP 62-040368 A

### SUMMARY OF INVENTION

### TECHNICAL PROBLEMS

When a material to be surface-treated, e.g., a grain oriented electrical steel sheet having no forsterite coating, is subjected to surface treatment such as coating formation by a PVD method using a sputtering target (hereinafter simply called "target"), the target is disposed in a reduced pressure space in a chamber and used under a high temperature condition. When the target is consumed with progression of the surface treatment, the target is replaced.

Meanwhile, it is necessary to entirely release the inside atmosphere of the chamber to the air and cool down the inside of the chamber every time a target is replaced. This causes poor productivity.

In particular, in the case where surface treatment using a target is continuously carried out on a material to be surface-treated that is conveyed, the operation of a surface treatment facility needs to be stopped every time a target is replaced, and this results in, for instance, a lower operating rate of the surface treatment facility.

When surface treatment is carried out by an ion plating method which is one of PVD methods, a magnet for plasma induction is disposed on the back side of a target (on the opposite side from the side closer to the material to be surface-treated). Therefore, a huge target cannot be used, and a relatively small target is used. Accordingly, a target is consumed more quickly, so that a target needs to be replaced more frequently.

The present invention has been made in view of the foregoing and an object of the invention is to provide a target replacement apparatus that enables easy replacement of a target used in a PVD method, as well as a surface treatment facility using the apparatus.

### SOLUTION TO PROBLEMS

The present inventors have made an intensive study and as a result found that when the structure described below is employed, the foregoing object is achieved. The invention has been thus completed.

Specifically, the present invention provides the following [1] to [21].
[1] A target replacement apparatus for use in replacement of a sputtering target, the sputtering target being used to carry out surface treatment by a physical vapor deposition method on a material to be surface-treated that is situated in a reduced pressure space of a chamber, the target replacement apparatus comprising:
   a target retaining portion retaining the sputtering target;
   an attachment and detachment mechanism used to detachably attach the target retaining portion to the chamber at a position where the sputtering target faces the material to be surface-treated that is situated in the reduced pressure space; and
   an isolating mechanism operable to isolate the target retaining portion attached to the chamber from the reduced pressure space in an openable and closable manner.
[2] The target replacement apparatus according to [1] above,
   wherein the material to be surface-treated is conveyed through the reduced pressure space and continuously subjected to surface treatment by use of the sputtering target.
[3] The target replacement apparatus according to [2] above,
   wherein the attachment and detachment mechanism is a mechanism used to arrange a plurality of the target retaining portions in parallel along a conveyance direction of the material to be surface-treated and attach separately the plurality of the target retaining portions to the chamber in a detachable manner, and
   wherein the isolating mechanism is a mechanism operable to isolate separately the plurality of the target retaining portions arranged in parallel along the conveyance direction from the reduced pressure space in an openable and closable manner.
[4] The target replacement apparatus according to [2] or [3] above,
   wherein the target retaining portion retains a plurality of the sputtering targets such that the plurality of the sputtering targets are aligned in a direction perpendicular to the conveyance direction of the material to be surface-treated.
[5] The target replacement apparatus according to [4] above,
   wherein a plurality of the sputtering targets are arranged in a linear manner along the conveyance direction of the material to be surface-treated.
[6] The target replacement apparatus according to [4] above,
   wherein a plurality of the sputtering targets are arranged in a staggered manner along the conveyance direction of the material to be surface-treated.
[7] The target replacement apparatus according to any one of [2] to [6] above,
   wherein the material to be surface-treated is conveyed in a longitudinal direction.
[8] The target replacement apparatus according to any one of [2] to [7] above,
   wherein the target replacement apparatus is disposed on each side of the material to be surface-treated that is conveyed.
[9] The target replacement apparatus according to any one of [1] to [8] above, further comprising a valve used to expose the target retaining portion isolated from the reduced pressure space, to the air.
[10] The target replacement apparatus according to any one of [1] to [9] above,
   wherein the material to be surface-treated is a metal band.
[11] The target replacement apparatus according to any one of [1] to [10] above,
   wherein the material to be surface-treated is a grain oriented electrical steel sheet having no forsterite coating.
[12] A surface treatment facility for continuously carrying out surface treatment, by a physical vapor deposition method using a sputtering target, on a material to be surface-treated that is conveyed, the surface treatment facility comprising:
   a chamber having a reduced pressure space therein, the material to be surface-treated being conveyed through the reduced pressure space;
   a target retaining portion retaining the sputtering target;
   an attachment and detachment mechanism used to detachably attach the target retaining portion to the chamber at a position where the sputtering target faces the material to be surface-treated that is conveyed through the reduced pressure space; and
   an isolating mechanism operable to isolate the target retaining portion attached to the chamber from the reduced pressure space in an openable and closable manner.
[13] The target replacement apparatus according to [12] above,
   wherein the attachment and detachment mechanism is a mechanism used to arrange a plurality of the target retaining portions in parallel along a conveyance direction of the material to be surface-treated and attach separately the plurality of the target retaining portions to the chamber in a detachable manner, and
   wherein the isolating mechanism is a mechanism operable to isolate separately the plurality of the target retaining portions arranged in parallel along the conveyance direction from the reduced pressure space in an openable and closable manner.
[14] The surface treatment facility according to [12] or [13] above,
   wherein the target retaining portion retains a plurality of the sputtering targets such that the plurality of the sputtering targets are aligned in a direction perpendicular to the conveyance direction of the material to be surface-treated.
[15] The surface treatment facility according to [14] above,
   wherein a plurality of the sputtering targets are arranged in a linear manner along the conveyance direction of the material to be surface-treated.
[16] The surface treatment facility according to [14] above,
   wherein a plurality of the sputtering targets are arranged in a staggered manner along the conveyance direction of the material to be surface-treated.
[17] The surface treatment facility according to any one of [12] to [16] above,
   wherein the material to be surface-treated is conveyed in a longitudinal direction.
[18] The surface treatment facility according to any one of [12] to [17] above,
   wherein the attachment and detachment mechanism and the isolating mechanism are disposed on each side of the material to be surface-treated that is conveyed.
[19] The surface treatment facility according to any one of [12] to [18] above, further comprising a valve used to expose the target retaining portion isolated from the reduced pressure space, to the air.
[20] The surface treatment facility according to any one of [12] to [19] above,
   wherein the material to be surface-treated is a metal band.
[21] The surface treatment facility according to any one of [12] to [20] above,
   wherein the material to be surface-treated is a grain oriented electrical steel sheet having no forsterite coating.

### ADVANTAGEOUS EFFECTS OF INVENTION

The present invention makes it possible to provide a target replacement apparatus that enables easy replacement of a target used in a PVD method, as well as a surface treatment facility using the apparatus.

### BRIEF DESCRIPTION OF DRAWINGS

[FIG. 1] FIG. 1 is a cross-sectional view showing a target replacement apparatus along with a chamber.
[FIG. 2] FIG. 2 is an exploded perspective view showing a target retaining portion.
[FIG. 3] FIG. 3 is a perspective view showing an attachment and detachment mechanism.
[FIG. 4] FIG. 4 is a perspective view showing the state where the target retaining portion is inserted in rail grooves.
[FIG. 5] FIG. 5 is a perspective view showing an isolating mechanism.
[FIG. 6] FIG. 6 is a cross-sectional view showing the state where a shutter plate at a position P1 covers an opening.
[FIG. 7] FIG. 7 is a cross-sectional view showing the state where the target retaining portion at the position P1 has been pulled out.
[FIG. 8] FIG. 8 is a schematic view showing an arrangement of targets.
[FIG. 9] FIG. 9 is a schematic view showing another arrangement of targets.
[FIG. 10] FIG. 10 is a cross-sectional view showing the state where the target replacement apparatuses are disposed on both sides of a material to be surface-treated that is conveyed.
[FIG. 11] FIG. 11 is a cross-sectional view showing the state where the target replacement apparatuses are disposed on both sides of a material to be surface-treated that is conveyed in a longitudinal direction.
[FIG. 12] FIG. 12 is a schematic view schematically showing a surface treatment facility.
[FIG. 13] FIG. 13 is a schematic view showing a surface treatment facility in which the target replacement apparatuses are disposed in a pretreatment chamber.

### DESCRIPTION OF EMBODIMENTS

Embodiments of the present invention are described below with reference to the drawings. However, the present invention should not be construed as being limited to the following embodiment. In the figures referred to below, some parts of members are cut away and illustrated.

### [Target Replacement Apparatus]

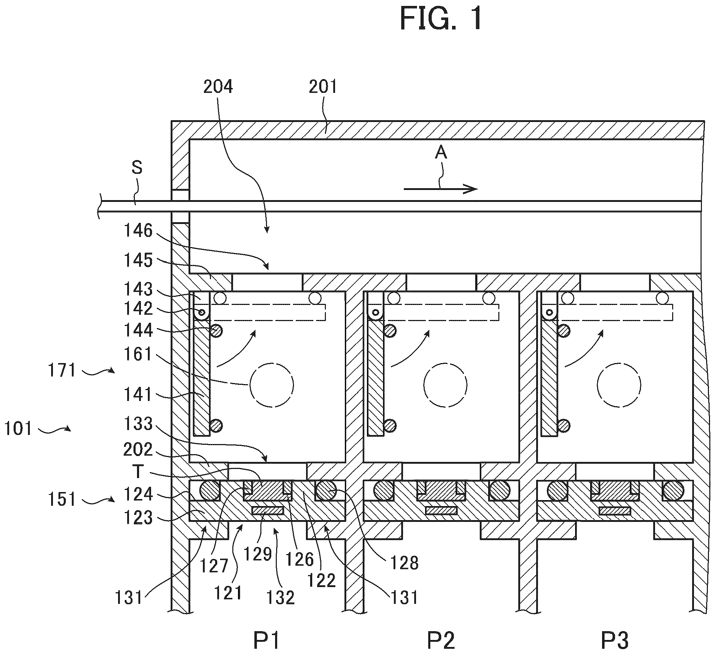

FIG. 1 is a cross-sectional view showing a target replacement apparatus 101 along with a chamber 201.

Air is discharged from the inside of the chamber 201 through an exhaust port (not shown) to form a reduced pressure space 204. A material S to be surface-treated is conveyed through the reduced pressure space 204 of the chamber 201 in a direction of arrow A (also called a conveyance direction). When the material S to be surface-treated is a rolled metal band, the material S to be surface-treated is conveyed in the rolling direction, the detail of which material S is described later.

In the reduced pressure space 204, surface treatment such as coating formation is continuously carried out by a PVD method on the material S to be surface-treated that is conveyed, using targets T. For surface treatment, sputtering or arc discharge is carried out with the targets T in the reduced pressure space 204. In surface treatment, each target T is heated by a heater (not shown).

As shown in FIG. 1, the target replacement apparatus 101 includes target retaining portions 121 retaining the targets T and also includes an attachment and detachment mechanism 151 and an isolating mechanism 171.

The attachment and detachment mechanism 151 is used to arrange a plurality of target retaining portions 121 in parallel along the conveyance direction of the material S to be surface-treated and attach separately the target retaining portions 121 to the chamber 201 in a detachable manner. The targets T retained by the target retaining portions 121 are positioned by means of the attachment and detachment mechanism 151 to face the material S to be surface-treated that is conveyed through the reduced pressure space 204.

The isolating mechanism 171 is operated to isolate each target retaining portion 121 attached to the chamber 201 from the reduced pressure space 204 in an openable and closable manner. To be more specific, the isolating mechanism 171 is operated to isolate separately the plurality of target retaining portions 121 arranged in parallel along the conveyance direction of the material S to be surface-treated from the reduced pressure space 204 in an openable and closable manner.

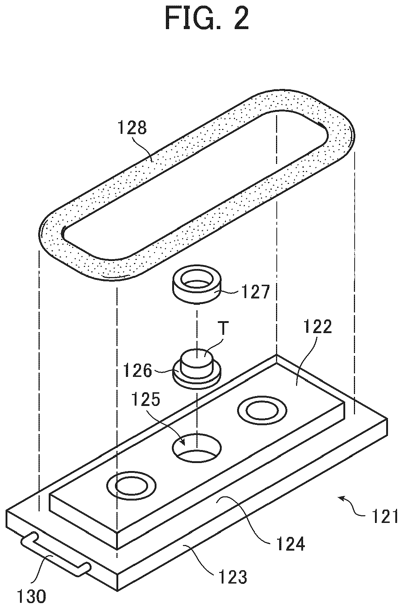

Next, the respective portions (the target retaining portion 121, the attachment and detachment mechanism 151 and the isolating mechanism 171) of the target replacement apparatus 101 are described in further detail with reference to FIGS. 2 to 5.

The target retaining portion 121 is described with reference to FIG. 2. Reference is also made to FIG. 1.

FIG. 2 is an exploded perspective view showing the target retaining portion 121. The target retaining portion 121 includes a sheet-type retaining portion body 122 elongated in one direction. The retaining portion body 122 has a protruding portion 123 protruding circumferentially. The protruding portion 123 forms a protruding surface 124. The protruding portion 123 is provided on its one edge face with a grip portion 130.

As shown in FIG. 2, recesses 125 in a cylindrical shape are provided in the retaining portion body 122 on one surface side (top surface side in FIG. 2) thereof. The targets T are placed in the recesses 125. The shape of the target T is not particularly limited and is preferably a round shape for the sake of the degree of freedom of handling and the efficiency of use of a raw material. The target T in this embodiment has a top hat shape and has a brim portion 126. Further, a ring-like member 127 is fitted into the recess 125 to fasten the brim portion 126 of the target T disposed in the recess 125. The ring-like member 127 is detachably engaged in the recess 125 by a known method. The target T is retained in the target retaining portion 121 in this manner.

As shown in FIG. 2, a sealing member 128 such as an O-ring is disposed on the protruding surface 124 of the protruding portion 123. The sealing member 128 is preferably bonded to the protruding surface 124.

Although not illustrated in FIG. 2, a magnet 129 (see FIG. 1) is embedded in the retaining portion body 122 to overlap the associated target T disposed in the recess 125. The magnet 129 is, for instance, a known magnet used in the ion plating method which is one of PVD methods.

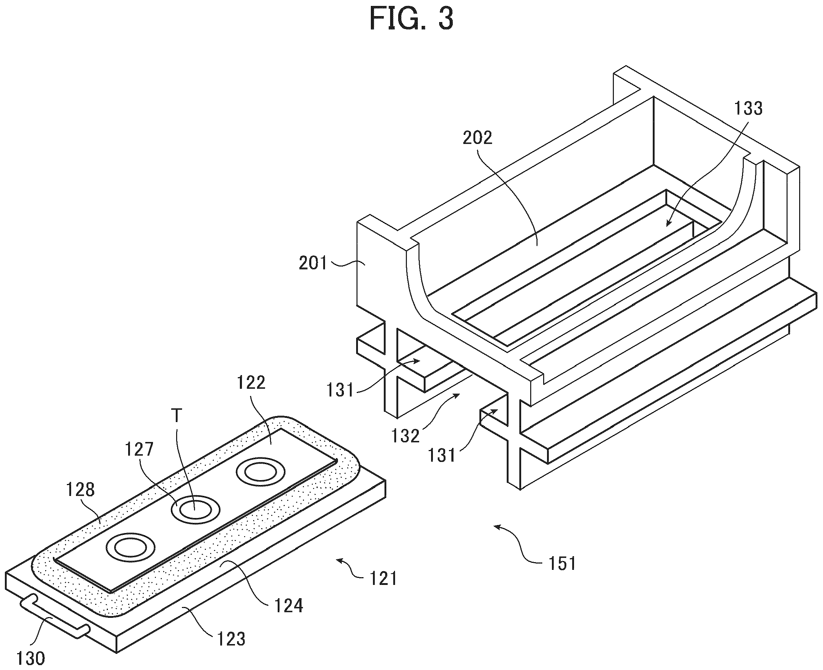

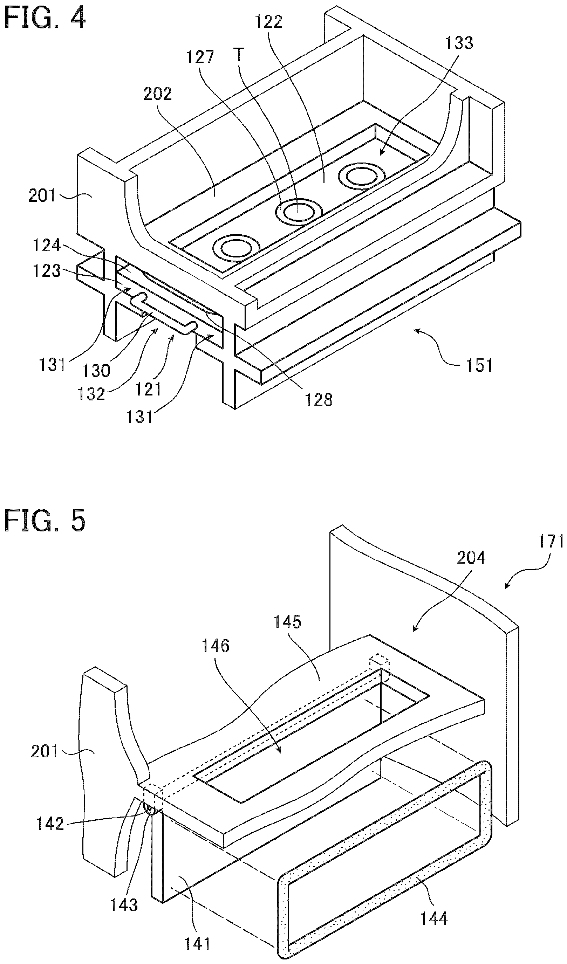

Next, the attachment and detachment mechanism 151 is described with reference to FIGS. 3 and 4. Reference is also made to FIG. 1.

FIG. 3 is a perspective view showing the attachment and detachment mechanism 151. Rail grooves 131 are formed from a chamber member 202 constituting the chamber 201. The rail grooves 131 are provided on one surface side of the material S to be surface-treated (under the material S to be surface-treated in FIG. 1) (not shown in FIG. 3) that is conveyed through the chamber 201, to extend in the width direction of the material S to be surface-treated. A pair of rail grooves 131 face each other across a gap 132. The protruding portion 123 of the target retaining portion 121 and the sealing member 128 are inserted into the pair of rail grooves 131. Thus, FIG. 3 is a perspective view showing the state before the target retaining portion 121 is inserted into the rail grooves 131.

FIG. 4 is a perspective view showing the state where the target retaining portion 121 is inserted in the rail grooves 131. The groove width (a distance in the vertical direction in FIG. 4) of the rail groove 131 is smaller (narrower) than the total thickness of the protruding portion 123 and the sealing member 128. Accordingly, when the target retaining portion 121 is inserted in the rail grooves 131, the sealing member 128 makes close contact with the chamber member 202. Thus, the reduced pressure space 204 of the chamber 201 is tightly sealed.

As shown in FIG. 4, in the state where the target retaining portion 121 is inserted in the rail grooves 131, the targets T are exposed from an opening 133 formed in the chamber member 202. Thus, the targets T retained by the target retaining portion 121 and the material S to be surface-treated that is conveyed through the chamber 201 are opposed to each other (see also FIG. 1).

The target retaining portion 121 inserted in the rail grooves 131 can be pulled out from the rail grooves 131 and detached from the chamber 201 by, for instance, holding the grip portion 130 to pull out the target retaining portion 121.

Thus, the chamber member 202, the rail grooves 131, the opening 133, the protruding portion 123, the sealing member 128 and other components constitute the attachment and detachment mechanism 151 used to detachably attach the target retaining portion or portions 121 to the chamber 201.

The attachment and detachment mechanism 151 is not limited to the embodiment described with reference to FIGS. 3 and 4.

For example, the target retaining portion 121 is not limited to the one pulled out (inserted) in the width direction of the material S to be surface-treated and may be the one detached in the direction away from the material S to be surface-treated (in the downward direction in FIG. 1) .

Next, the isolating mechanism 171 is described with reference to FIG. 5. Reference is also made to FIG. 1.

FIG. 5 is a perspective view showing the isolating mechanism 171. An opening 146 is formed using a chamber member 145 at a position between the material S to be surface-treated that is conveyed through the chamber 201, and the attachment and detachment mechanism 151. The opening 146 normally stay open. Accordingly, the material S to be surface-treated that is conveyed and the targets T directly face each other (see FIG. 1).

A shutter plate 141 is disposed on the chamber member 145 on the side closer to the attachment and detachment mechanism 151. The shutter plate 141 is rotated about a shaft 142 by an electrical effect. The shaft 142 is rotatably retained by a shaft retaining portion 143 fixed on the chamber member 145. The axial direction of the shaft 142 is the width direction of the material S to be surface-treated.

As shown in FIG. 5, a sealing member 144 such as an O-ring is disposed on one surface side (the side to cover the opening 146) of the shutter plate 141. The sealing member 144 is preferably bonded to the shutter plate 141.

The shutter plate 141 is rotated to close the opening 146 by an electrical effect, whereby the sealing member 144 makes close contact with the chamber member 145. Thus, the target retaining portion 121 attached to the chamber 201 is isolated from the reduced pressure space 204. The shutter plate 141 covering the opening 146 is rotated to open the opening 146 by an electrical effect.

Thus, the shutter plate 141, the shaft 142, the shaft retaining portion 143, the sealing member 144, the chamber member 145, the opening 146 and other components constitute the isolating mechanism 171.

The isolating mechanism 171 is not limited to the embodiment described with reference to FIG. 5.

For example, the shutter plate 141 is not limited to the one being rotated about the shaft 142 and may be the one pulled out (inserted) in the width direction of the material S to be surface-treated.

Further, as shown in FIG. 1, a valve 161 is provided between the opening 146 and the target retaining portion 121 inserted in the rail grooves 131. The valve 161 is disposed outside the chamber 201 and connected to the inside of the chamber 201. When the valve 161 is opened, the outside and the inside of the chamber 201 communicate with each other.

When the shutter plate 141 covers the opening 146 to isolate the target retaining portion 121 from the reduced pressure space 204, once the valve 161 is opened, the target retaining portion 121 is exposed to the air.

In the configuration as above, all the shutter plates 141 are normally open and do not cover the openings 146, as shown in FIG. 1. In addition, the target retaining portions 121 are inserted in all the pairs of rail grooves 131. At this time, since the sealing members 128 of the target retaining portions 121 make close contact with the chamber member 202, the reduced pressure space 204 is tightly sealed.

The material S to be surface-treated is conveyed through the reduced pressure space 204 in the condition as above. Surface treatment is continuously carried out on the material S to be surface-treated that is conveyed, using the targets T. The targets T of all the target retaining portions 121 are used for surface treatment of the material S to be surface-treated.

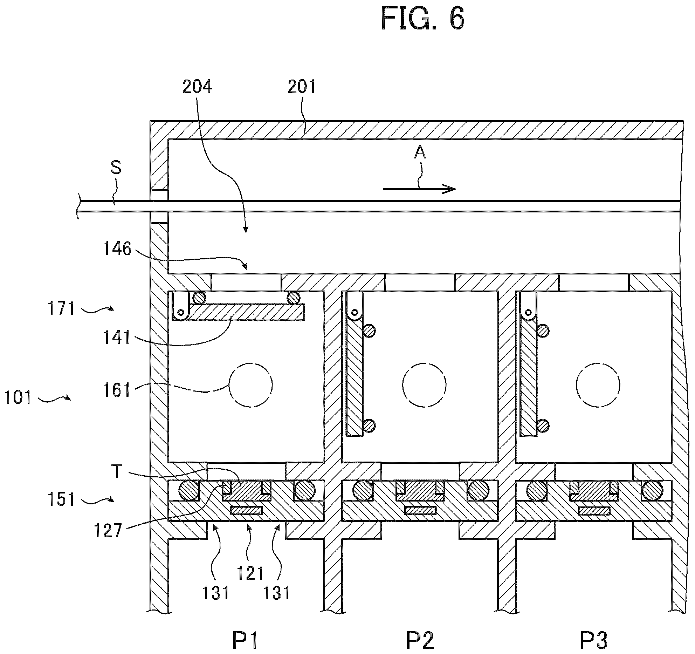

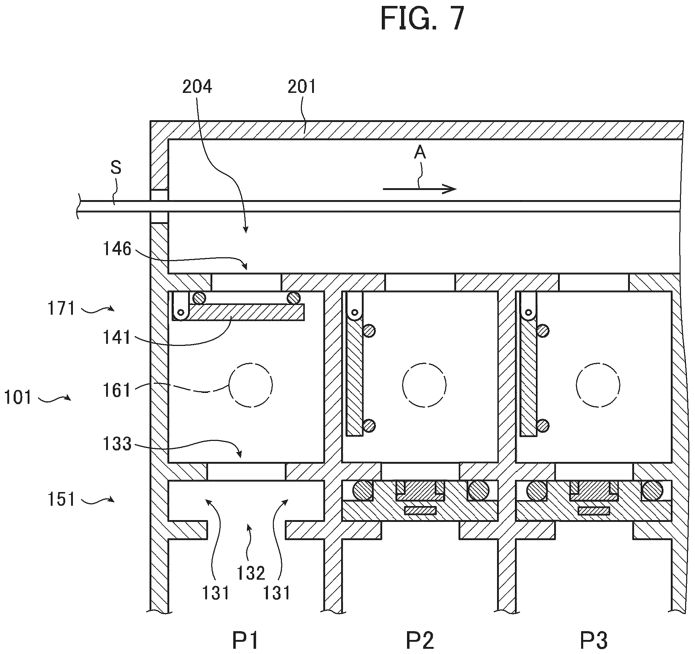

Now, the case where a target T at a position P1 on the most upstream side in the conveyance direction of the material S to be surface-treated is replaced is described by reference to FIGS. 6 and 7.

When to replace a target T is typically the time when a target T used for surface treatment has been consumed. Such timing may be experimentally determined or determined by sensing a decrease over time in the mass of a target T by means of a known mechanism (not shown) and using the sensing result as the basis for determination.

FIG. 6 is a cross-sectional view showing the state where the shutter plate 141 at the position P1 covers the opening 146. First, heating of the target T at the position P1 where replacement is carried out is stopped. Then, as shown in FIG. 6, the shutter plate 141 at the position P1 is rotated to close the opening 146, whereby the target retaining portion 121 at the position P1 is isolated from the reduced pressure space 204. Subsequently, the valve 161 at the position P1 is opened, whereby the target T of the target retaining portion 121 at the position P1 is exposed to the air and cooled down. At this time, the shutter plate 141 covering the opening 146 is pressed by the atmospheric pressure, leading to increased sealing tightness.

FIG. 7 is a cross-sectional view showing the state where the target retaining portion 121 at the position P1 has been pulled out. Next, with the shutter plate 141 at the position P1 covering the opening 146, the target retaining portion 121 at the position P1 is pulled out as shown in FIG. 7. At this time, the grip portion 130 may be held to pull out the target retaining portion 121 along the rail grooves 131.

In the target retaining portion 121 thus pulled out, the ring-like member 127 is removed, and the target T which has been consumed is taken out from the recess 125. Then, a new target T is disposed in the recess 125, whereafter the ring-like member 127 is fitted thereto. Thus, the new target T is retained in the target retaining portion 121.

The target retaining portion 121 retaining the new target T is inserted into the pair of rail grooves 131 at the position P1. Thus, the target retaining portion 121 at the position P1 again assumes the same state as in FIG. 6. Heating of the new target T at the position P1 may be started at this point of time. Then, the valve 161 is closed, and thereafter, the shutter plate 141 at the position P1 is rotated to open the opening 146. Thus, the shutter plate 141 at the position P1 again assumes the same state as in FIG. 1. The target T at the position P1 is exposed to the reduced pressure space 204 again and starts to be used for surface treatment of the material S to be surface-treated. Thus, only the target T at the position P1 can be easily replaced without entirely releasing the inside atmosphere of the chamber 201 to the air and cooling down the inside of the chamber 201.

After the target T at the position P1 is replaced, another target T for example on the more downstream side than the position P1 in the conveyance direction (at the position P2, P3, or the like) can be replaced in the same manner.

Even while a target T at one position (e.g., position P1) is replaced, the material S to be surface-treated is conveyed and continuously subjected to surface treatment using targets T at other positions (e.g., positions P2, P3, and the like).

Therefore, according to this embodiment, a target T can be replaced without stopping the operation (conveyance of the material S to be surface-treated, and continuous surface treatment of the material S to be surface-treated that is conveyed).

The number of the target retaining portions 121 is preferably at least two in order to achieve the above effect. In other words, there are preferably provided, at least, one target retaining portion 121 whose target T is replaced and another target retaining portion 121 used for surface treatment during the replacement.

The conveyance speed can be increased with increasing number of the target retaining portions 121 disposed along the conveyance direction (rolling direction) of the material S to be surface-treated. Therefore, the number of the target retaining portions 121 is more preferably at least four. However, if the number thereof is too large, problems may arise; for instance, the chamber 201 may become too long. Therefore, the number of the target retaining portions 121 is preferably up to eighty.

The number of the target retaining portions 121 removed from the chamber 201 at a time is not particularly limited, and to replace a target T without stopping the operation, at least one target retaining portion 121 is preferably not removed.

The installation of the valve 161 as well as its opening and closing operation may be omitted. For instance, after the shutter plate 141 is rotated and the opening 146 is closed (see FIG. 6), the target retaining portion 121 may be pulled out (see FIG. 7) without opening the valve 161 if it is possible. In this case, by being pulled out, the target retaining portion 121 is naturally exposed to the air and cooled down. After the target retaining portion 121 is pulled out, the shutter plate 141 covering the opening 146 is pressed by the atmospheric pressure, so that sealing tightness increases.

Next, in the target retaining portion 121 thus pulled out, a target T which has been consumed is taken out and a new target T is retained in the same manner as above. The target retaining portion 121 retaining the new target T is inserted into the rail grooves 131.

Then, the shutter plate 141 is rotated to open the opening 146 while heating of the new target T is started. Thus, the new target T is exposed to the reduced pressure space 204 again and starts to be used for surface treatment of the material S to be surface-treated.

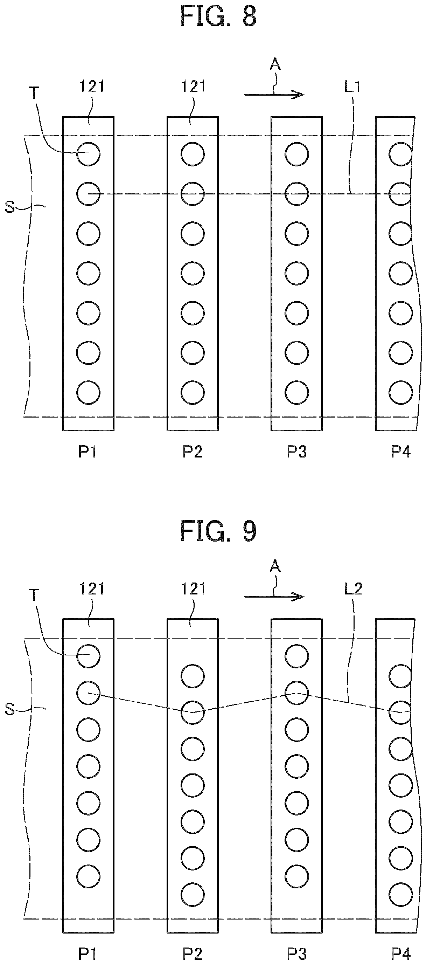

Next, the arrangement of the targets T is described with reference to FIGS. 8 and 9.

FIG. 8 is a schematic view showing an arrangement of the targets T. The number of the targets T in each target retaining portion 121 is not particularly limited and suitably set in accordance with the length of the material S to be surface-treated in the width direction of the material S. In FIGS. 2 to 4, an example is illustrated in which three targets T are retained in one target retaining portion 121 along the width direction of the material S to be surface-treated. However, those figures are merely schematic views, and for example, seven targets T may be retained in one target retaining portion 121 as shown in FIG. 8.

In FIG. 8, the targets T of respective target retaining portions 121 are arranged in a linear manner along the conveyance direction of the material S to be surface-treated (the direction of arrow A), as shown by imaginary line L1.

FIG. 9 is a schematic view showing another arrangement of the targets T. As shown in FIG. 9, the targets T of respective target retaining portions 121 may be arranged in a staggered manner (to have a zigzag shape) along the conveyance direction of the material S to be surface-treated (the direction of arrow A), as shown by imaginary line L2. This configuration is preferred because surface treatment using the targets T is carried out evenly and entirely across the width direction of the material S to be surface-treated.

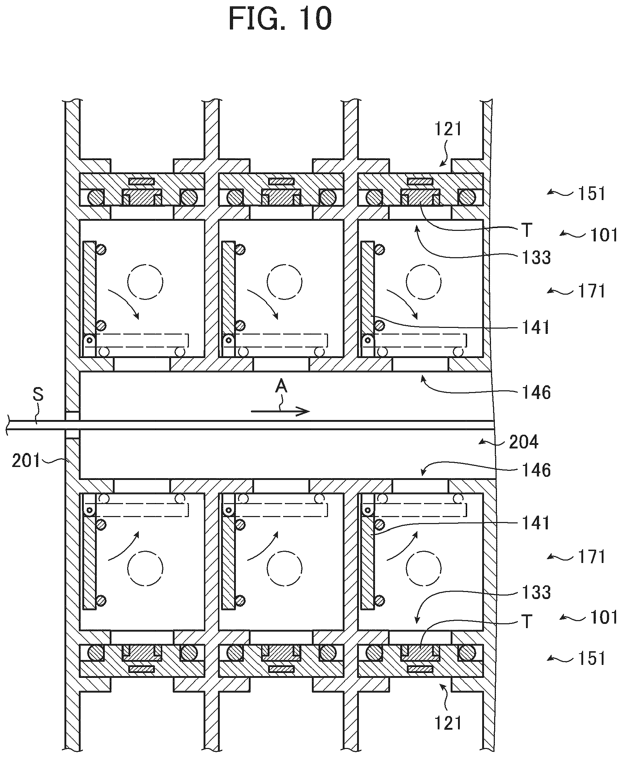

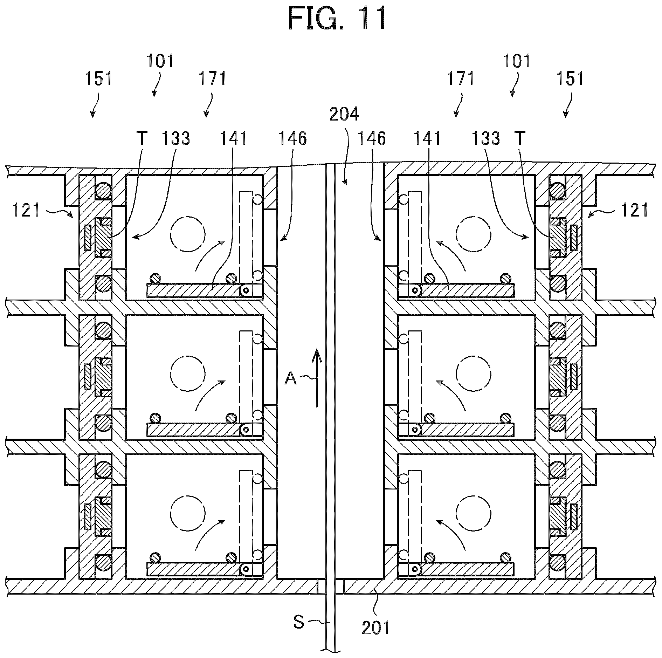

Next, modifications of the arrangement of the target replacement apparatuses 101 are described with reference to FIGS. 10 and 11.

FIG. 10 is a cross-sectional view showing the state where the target replacement apparatuses 101 are disposed on both sides of the material S to be surface-treated that is conveyed. In FIG. 10, the targets T are disposed on both sides of the material S to be surface-treated that is conveyed in the chamber 201.

In the case of forming coatings on both surfaces of the material S to be surface-treated that is conveyed, if coating formation is carried out on a surface-by-surface basis, deflection may occur in the surface-treated material S after a coating is formed only on one surface thereof, and this deflection may cause nonuniform coatings.

As shown in FIG. 10, however, when the targets T are disposed on both sides of the material S to be surface-treated, coatings can be simultaneously formed on both surfaces of the material S to be surface-treated that is conveyed, so that uniform coatings can be formed.

FIG. 11 is a cross-sectional view showing the state where the target replacement apparatuses 101 are disposed on both sides of the material S to be surface-treated that is conveyed in a longitudinal direction. In FIG. 11, the material S to be surface-treated is conveyed in the longitudinal direction (upward direction from below in FIG. 11). Even in this case, the targets T and the target replacement apparatus or apparatuses 101 can be disposed on either or both sides of the material S to be surface-treated that is conveyed. As shown in FIG. 11, when the apparatuses are disposed on both sides of the material S to be surface-treated, coatings can be simultaneously formed on both surfaces of the material S to be surface-treated that is conveyed, so that uniform coatings can be formed.

### [Surface Treatment Facility]

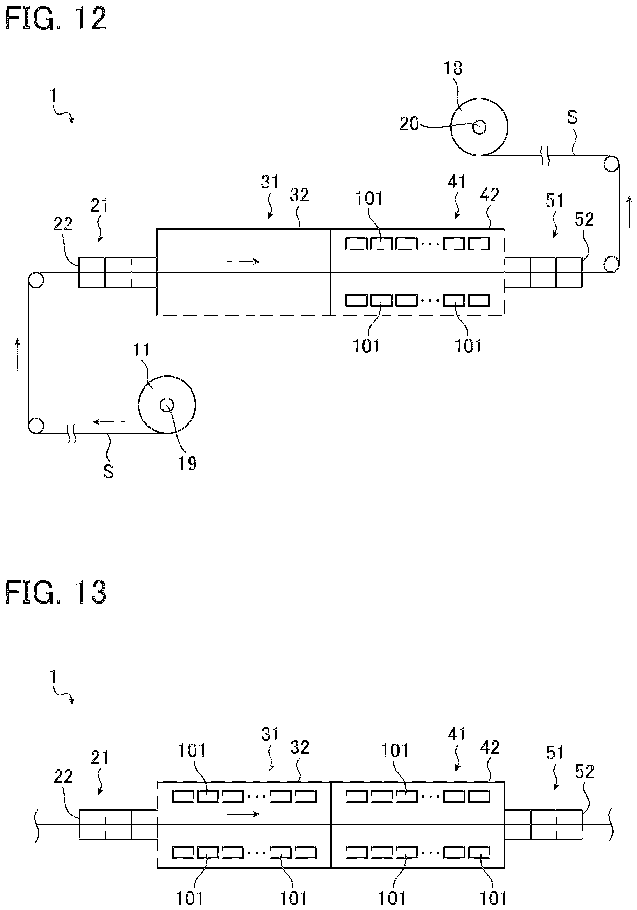

Next, one embodiment of the surface treatment facility of the invention is described below with reference to FIG. 12.

FIG. 12 is a schematic view schematically showing a surface treatment facility 1. The surface treatment facility 1 includes a payoff reel 19. A coil 11 before conveyance formed from the material S to be surface-treated is hung on the payoff reel 19. The material S to be surface-treated that is pulled out from the payoff reel 19 is passed through various sections of the surface treatment facility 1 and then again wound by a winding reel 20 to form a coil 18 after conveyance.

The surface treatment facility 1 includes the entry decompression facility 21, the pretreatment facility 31, the coating formation facility 41 and the exit decompression facility 51 in order along the direction in which the material S to be surface-treated is conveyed.

The entry decompression facility 21 has multistage entry decompression chambers 22. The pretreatment facility 31 has a pretreatment chamber 32. The coating formation facility 41 has a coating formation chamber 42. The exit decompression facility 51 has multistage exit decompression chambers 52.

The material S to be surface-treated is conveyed in an air atmosphere except for the inside of the entry decompression chambers 22, the pretreatment chamber 32, the coating formation chamber 42 and the exit decompression chambers 52.

The composition and the type of the material S to be surface-treated are not particularly limited, and examples of the material S to be surface-treated include a metal band, a film and a semiconductor.

In the following, the case where the material S to be surface-treated is a grain oriented electrical steel sheet having undergone final annealing, which is one type of metal band, is taken as an example and described. That is, the coil 11 before conveyance formed from a grain oriented electrical steel sheet S having undergone final annealing (hereinafter also simply called "steel sheet S") is hung on the payoff reel 19.

Typically, a grain oriented electrical steel sheet having undergone final annealing has a forsterite coating.

When the steel sheet S has a forsterite coating, the steel sheet S is polished, for instance, in a polishing facility (not shown) to remove the forsterite coating before being introduced into the entry decompression chambers 22 of the entry decompression facility 21. When the steel sheet S does not have an oxide coating such as a forsterite coating, the steel sheet S is introduced into the entry decompression chambers 22 of the entry decompression facility 21 without a polishing process.

The steel sheet S (the grain oriented electrical steel sheet having no forsterite coating) is introduced into the entry decompression chambers 22 of the entry decompression facility 21. The internal pressure in the multistage entry decompression chambers 22 is reduced stepwise toward the pretreatment chamber 32 and the coating formation chamber 42. Thus, the pressure applied to the steel sheet S approaches the internal pressure in the pretreatment chamber 32 and the coating formation chamber 42 from the atmospheric pressure.

Since the internal pressure is changed stepwise, wavy distortion of the steel sheet S that may be caused by the pressure difference can be minimized. The number of the steps of the entry decompression chambers 22 is preferably at least three.

The steel sheet S (the grain oriented electrical steel sheet having no forsterite coating) having been passed through the entry decompression chambers 22 is introduced into the pretreatment chamber 32 of the pretreatment facility 31 and subjected to pretreatment under a reduced pressure condition to remove impurities adhering to the surface.

The steel sheet S (the grain oriented electrical steel sheet having no forsterite coating) having undergone the pretreatment is introduced into the coating formation chamber 42 of the coating formation facility 41. A coating is formed on the surface of the steel sheet S conveyed through the coating formation chamber 42 under a reduced pressure condition.

The steel sheet S on which the coating has been formed is introduced into the exit decompression chambers 52 of the exit decompression facility 51. The internal pressure in the multistage exit decompression chambers 52 is increased stepwise with distance away from the coating formation chamber 42. Thus, the pressure applied to the steel sheet S returns from the internal pressure in the pretreatment chamber 32 and the coating formation chamber 42 to the atmospheric pressure.

Since the internal pressure is changed stepwise, wavy distortion of the steel sheet S that may be caused by the pressure difference can be minimized. The number of the steps of the exit decompression chambers 52 is preferably at least three.

The steel sheet S having been passed through the exit decompression facility 51 is then wound around the winding reel 20 to form the coil 18 after conveyance.

Next, the pretreatment facility 31 and the coating formation facility 41 are described in further detail. First, the coating formation facility 41 is described.

### <Coating Formation Facility>

Air is discharged from the inside of the coating formation chamber 42 of the coating formation facility 41 to form a reduced pressure space. A coating is formed on the surface of the steel sheet S (the grain oriented electrical steel sheet having no forsterite coating) that is conveyed through the reduced pressure space of the coating formation chamber 42 by a PVD (Physical Vapor Deposition) method.

Raw material gas (atmospheric gas) for coating formation, such as nitrogen gas for instance, is introduced into the coating formation chamber 42. The steel sheet S is heated, and a coating such as a nitride coating is formed on the surface of the steel sheet S.

For a means for heating the steel sheet S, since the inside of the coating formation chamber 42 is the reduced pressure space, the use of a burner or such devices is naturally improper. However, any means may be suitably adopted without particular limitation as long as it is a means that does not require oxygen, such as induction heating (IH), electron beam irradiation, laser light, or infrared light.

A preferred PVD method is an ion plating method. For ease of manufacture, the coating formation temperature is preferably 300°C to 600°C, and the pressure (internal pressure) in the coating formation chamber 42 is preferably 0.1 to 100 Pa. During the coating formation, a bias voltage of -10 to -100 V is preferably applied with the steel sheet S serving as the cathode. The coating formation rate can be increased when plasma is used for ionization of a raw material.

For the coating formed on the steel sheet S, a nitride coating is preferred, a metal nitride coating is more preferred, and a metal nitride coating including at least one metal selected from the group consisting of Zn, V, Cr, Mn, Fe, Co, Ni, Cu, Ti, Y, Nb, Mo, Hf, Zr, W and Ta is even more preferred. These coatings can easily have a rock salt structure, and since this structure easily matches the body-centered cubic lattice of the steel substrate of the steel sheet S, the adhesion of the coating can be improved.

The coating formed on the steel sheet S may be a single layer coating or a multilayer coating.

In the coating formation chamber 42, gas generated upon reaction on the surface of the steel sheet S and raw material gas introduced are dominant in terms of the amount. Meanwhile, when gas is excessively discharged, the raw material gas may not be sufficiently delivered to the steel sheet S. In consideration of these points, gas is discharged to achieve a desired internal pressure (the same applies to the pretreatment chamber 32).

In the figures, exhaust ports, inlet ports for introducing the raw material gas, and the like of the coating formation chamber 42 are not illustrated (the same applies to the pretreatment chamber 32).

In the coating formation chamber 42, the amount of discharged gas is preferably 0.5 to 1 time as much as the amount of introduced raw material gas.

In this embodiment, the attachment and detachment mechanisms 151 and the isolating mechanisms 171 (neither of which are shown in FIG. 12) of the plurality of target replacement apparatuses 101 as described with reference to FIGS. 1 to 7 are disposed on the bottom surface side and the top surface side of the conveyed steel sheet S (see FIG. 10) in the coating formation chamber 42 that is a chamber. The steel sheet S may be conveyed in a longitudinal direction (see FIG. 11) in the coating formation chamber 42. The above-described valves 161 (not shown in FIG. 12) are disposed in the coating formation chamber 42.

In coating formation, targets are used as a raw material of the resulting coating. Each target retaining portion 121 (not shown in FIG. 12) retains a plurality of targets such that the targets are aligned in a direction perpendicular to the conveyance direction of the steel sheet S. A plurality of targets may be arranged in a linear manner (see FIG. 8) or a staggered manner (see FIG. 9) along the conveyance direction of the steel sheet S.

According to the target replacement apparatus 101, when a target at a certain position in the conveyance direction of the steel sheet S is consumed, the target at that position can be easily replaced without stopping the operation of the surface treatment facility 1.

### <Pretreatment Facility>

Next, the pretreatment facility 31 (pretreatment chamber 32) disposed on the upstream side of the coating formation facility 41 (coating formation chamber 42) is described.

The steel sheet S having been passed through the entry decompression chambers 22 is introduced into the pretreatment chamber 32 of the pretreatment facility 31 and subjected to the pretreatment in which impurities such as oxides adhering to the surface of the steel sheet S are removed under a reduced pressure condition.

The pretreatment prior to coating formation allows a coating (e.g., a nitride coating) later formed in the coating formation facility 41 to have remarkably improved adhesion to the steel sheet S. Therefore, although not essential, it is preferable to provide the pretreatment facility 31.

A favorable method of the pretreatment is ion sputtering. In the case of ion sputtering, preferred examples of ion species for use include ions of inert gases such as argon and nitrogen and ions of metals such as Ti and Cr.

The pressure in the pretreatment chamber 32 is reduced, and the internal pressure of the pretreatment chamber 32 is preferably 0.0001 to 1 Pa in order to increase the mean free path of sputtering ions.

A bias voltage of -100 to -1000 V is preferably applied with the steel sheet S serving as the cathode.

FIG. 13 is a schematic view showing a surface treatment facility 1 in which the target replacement apparatuses 101 are disposed in the pretreatment chamber 32. In FIG. 13, part of the surface treatment facility 1 is not illustrated.

When ions of a metal such as Ti or Cr are used in the pretreatment in the pretreatment chamber 32, the pretreatment can be carried out using a metal target by a PVD method (particularly, the ion plating method).

In this case, as shown in FIG. 13 for instance, the attachment and detachment mechanisms 151 and the isolating mechanisms 171 (neither of which are shown in FIG. 13) of the plurality of target replacement apparatuses 101 as described with reference to FIGS. 1 to 7 can be disposed on the bottom surface side and the top surface side of the conveyed steel sheet S (see FIG. 10) in the pretreatment chamber 32 that is a chamber. The steel sheet S may be conveyed in a longitudinal direction (see FIG. 11) in the pretreatment chamber 32. The above-described valves 161 (not shown in FIG. 13) are disposed in the pretreatment chamber 32.

Owing to the pretreatment chamber 32 as shown in FIG. 13, the pretreatment can be carried out simultaneously from the both sides of the steel sheet S using the targets. At this time, each target retaining portion 121 (not shown in FIG. 13) retains a plurality of targets such that the targets are aligned in a direction perpendicular to the conveyance direction of the steel sheet S. A plurality of targets may be arranged in a linear manner (see FIG. 8) or a staggered manner (see FIG. 9) along the conveyance direction of the steel sheet S.

Owing to the use of the target replacement apparatus 101, when a target at a certain position in the conveyance direction of the steel sheet S is consumed, the target at that position can be easily replaced without stopping the operation of the surface treatment facility 1.

### EXAMPLES

The present invention is specifically described below with reference to examples. However, the present invention is not limited thereto.

### <Example 1>

A coil 11 before conveyance (total mass: 8 t) of a grain oriented electrical steel sheet S (sheet thickness: 0.23 mm) having undergone final annealing was set in the surface treatment facility 1 described with reference to FIG. 12, and coating formation was carried out. The conveyance speed of the steel sheet S was set to 30 m/min. To be more specific, the steel sheet S from which a forsterite coating had been removed by mechanical polishing was introduced into the pretreatment chamber 32 to remove impurities from the surfaces by Ar ion sputtering. Subsequently, a TiN coating (coating thickness: 0.3 µm) was formed on each surface of the steel sheet S by a PVD method in the coating formation chamber 42. The PVD method was the ion plating method, and the coating formation temperature was 400°C.

In Example 1, ten target replacement apparatuses 101 were disposed along the conveyance direction of the steel sheet S in the coating formation chamber 42, as shown in FIG. 12. Each target retaining portion 121 (not shown in FIG. 12) retained three targets such that the targets are aligned in the width direction of the steel sheet S. Each target had a diameter of 100 mm and a height of 50 mm.

In Example 1, two target retaining portions 121 (not shown in FIG. 12) were together pulled out every 2 hours, and old targets having been used in coating formation and thereby consumed were replaced by new and unused targets. The time to start using new targets in coating formation was set to be exactly 2 hours after the use of corresponding old targets in coating formation was stopped. In other words, in Example 1, the number of target arrays in use for coating formation was always eight.

The coating thickness of the TiN coating formed on each surface of the steel sheet S was examined on the exit side of the coating formation chamber 42. The coating thickness was examined by measuring the Ti intensity using a fluorescent X-ray.

The examination results revealed that the coating thickness varied very slightly as a whole.

The maintenance such as entirely releasing the inside atmosphere of the coating formation chamber 42 to the air and cooling down the inside thereof was not necessary during the test that continued 1000 hours. This made it possible to maximize the operating rate of the surface treatment facility 1 during the test. Specifically, the operating rate was about 99%.

### <Comparative Example 1>

Targets were fixed to the inside of the coating formation chamber 42 without the target replacement apparatus 101. The number of target arrays in use for coating formation was set to eight, as with Example 1. The number of targets in each array was three in the width direction of the steel sheet S.

With the other conditions being set to be the same as those of Example 1, the coating formation was carried out, and the coating thickness of the TiN coating formed on each surface of the steel sheet S was examined on the exit side of the coating formation chamber 42.

The examination results revealed that while there was almost no difference in coating thickness between the opposite surfaces and the coatings were uniformly formed at the beginning of the coating formation, the coating thickness started decreasing approximately 8 hours after the start of the coating formation, and substantially no coating was formed when 10 hours had elapsed. In other words, it was revealed that the maintenance was required every 8 hours in Comparative Example 1 in which the targets were fixed to the inside of the coating formation chamber 42.

In the maintenance conducted every 8 hours, it took approximately 3 hours to release the inside atmosphere of the coating formation chamber 42 and cool down the inside thereof and approximately 5 hours to again discharge air and heat the chamber. Accordingly, the operating rate of the surface treatment facility 1 during the test that continued 1000 hours was about 50%.

### REFERENCE SIGNS LIST

1 surface treatment facility
11 coil before conveyance
18 coil after conveyance
19 payoff reel
20 winding reel
21 entry decompression facility
22 entry decompression chamber
31 pretreatment facility
32 pretreatment chamber (chamber)
41 coating formation facility
42 coating formation chamber (chamber)
51 exit decompression facility
52 exit decompression chamber
101 target replacement apparatus
121 target retaining portion
122 retaining portion body
123 protruding portion
124 protruding surface
125 recess
126 brim portion
127 ring-like member
128 sealing member
129 magnet
130 grip portion
131 rail groove
132 gap
133 opening
141 shutter plate
142 shaft
143 shaft retaining portion
144 sealing member
145 chamber member
146 opening
151 attachment and detachment mechanism
161 valve
171 isolating mechanism
201 chamber
202 chamber member
204 reduced pressure space
A arrow
S material to be surface-treated (grain oriented electrical steel sheet having undergone final annealing)
T target
P1 position
P2 position
P3 position

## Claims

1. A target replacement apparatus for use in replacement of a sputtering target, the sputtering target being used to carry out surface treatment by a physical vapor deposition method on a material to be surface-treated that is situated in a reduced pressure space of a chamber, the target replacement apparatus comprising:
a target retaining portion retaining the sputtering target;
an attachment and detachment mechanism used to detachably attach the target retaining portion to the chamber at a position where the sputtering target faces the material to be surface-treated that is situated in the reduced pressure space; and
an isolating mechanism operable to isolate the target retaining portion attached to the chamber from the reduced pressure space in an openable and closable manner.

2. The target replacement apparatus according to claim 1,
wherein the material to be surface-treated is conveyed through the reduced pressure space and continuously subjected to surface treatment by use of the sputtering target.

3. The target replacement apparatus according to claim 2,
wherein the attachment and detachment mechanism is a mechanism used to arrange a plurality of the target retaining portions in parallel along a conveyance direction of the material to be surface-treated and attach separately the plurality of the target retaining portions to the chamber in a detachable manner, and
wherein the isolating mechanism is a mechanism operable to isolate separately the plurality of the target retaining portions arranged in parallel along the conveyance direction from the reduced pressure space in an openable and closable manner.

4. The target replacement apparatus according to claim 2 or 3,
wherein the target retaining portion retains a plurality of the sputtering targets such that the plurality of the sputtering targets are aligned in a direction perpendicular to the conveyance direction of the material to be surface-treated.

5. The target replacement apparatus according to claim 4,
wherein a plurality of the sputtering targets are arranged in a linear manner along the conveyance direction of the material to be surface-treated.

6. The target replacement apparatus according to claim 4,
wherein a plurality of the sputtering targets are arranged in a staggered manner along the conveyance direction of the material to be surface-treated.

7. The target replacement apparatus according to any one of claims 2 to 6,
wherein the material to be surface-treated is conveyed in a longitudinal direction.

8. The target replacement apparatus according to any one of claims 2 to 7,
wherein the target replacement apparatus is disposed on each side of the material to be surface-treated that is conveyed.

9. The target replacement apparatus according to any one of claims 1 to 8, further comprising a valve used to expose the target retaining portion isolated from the reduced pressure space, to the air.

10. The target replacement apparatus according to any one of claims 1 to 9,
wherein the material to be surface-treated is a metal band.

11. The target replacement apparatus according to any one of claims 1 to 10,
wherein the material to be surface-treated is a grain oriented electrical steel sheet having no forsterite coating.

12. A surface treatment facility for continuously carrying out surface treatment, by a physical vapor deposition method using a sputtering target, on a material to be surface-treated that is conveyed, the surface treatment facility comprising:
a chamber having a reduced pressure space therein, the material to be surface-treated being conveyed through the reduced pressure space;
a target retaining portion retaining the sputtering target;
an attachment and detachment mechanism used to detachably attach the target retaining portion to the chamber at a position where the sputtering target faces the material to be surface-treated that is conveyed through the reduced pressure space; and
an isolating mechanism operable to isolate the target retaining portion attached to the chamber from the reduced pressure space in an openable and closable manner.

13. The target replacement apparatus according to claim 12,
wherein the attachment and detachment mechanism is a mechanism used to arrange a plurality of the target retaining portions in parallel along a conveyance direction of the material to be surface-treated and attach separately the plurality of the target retaining portions to the chamber in a detachable manner, and
wherein the isolating mechanism is a mechanism operable to isolate separately the plurality of the target retaining portions arranged in parallel along the conveyance direction from the reduced pressure space in an openable and closable manner.

14. The surface treatment facility according to claim 12 or 13,
wherein the target retaining portion retains a plurality of the sputtering targets such that the plurality of the sputtering targets are aligned in a direction perpendicular to the conveyance direction of the material to be surface-treated.

15. The surface treatment facility according to claim 14,
wherein a plurality of the sputtering targets are arranged in a linear manner along the conveyance direction of the material to be surface-treated.

16. The surface treatment facility according to claim 14,
wherein a plurality of the sputtering targets are arranged in a staggered manner along the conveyance direction of the material to be surface-treated.

17. The surface treatment facility according to any one of claims 12 to 16,
wherein the material to be surface-treated is conveyed in a longitudinal direction.

18. The surface treatment facility according to any one of claims 12 to 17,
wherein the attachment and detachment mechanism and the isolating mechanism are disposed on each side of the material to be surface-treated that is conveyed.

19. The surface treatment facility according to any one of claims 12 to 18, further comprising a valve used to expose the target retaining portion isolated from the reduced pressure space, to the air.

20. The surface treatment facility according to any one of claims 12 to 19,
wherein the material to be surface-treated is a metal band.

21. The surface treatment facility according to any one of claims 12 to 20,
wherein the material to be surface-treated is a grain oriented electrical steel sheet having no forsterite coating.
